# DEMANDE DE BREVET EUROPEEN

(11) **EP 3 648 166 A1**
(43) Date de publication de la demande: **06.05.2020**
(21) Numéro de dépôt: 19205681.0
(22) Date de dépôt: 28.10.2019
(51) Int. Cl.: H01L 27/15, H01L 29/08, H01L 33/00, H01L 27/02, H01S 5/062

(54) **TRANSISTOR BIPOLAIRE A EMISSION LUMINEUSE**

(30) Priorité: 31.10.2018 FR 1860072
(71) Demandeur: Commissariat à l'énergie atomique et aux énergies alternatives, 75015 Paris (FR)
(72) Inventeur: DAAMI, Anis, 38054 GRENOBLE CEDEX 09 (FR); FERRON, Alexandre, 38054 GRENOBLE CEDEX 09 (FR); SUHM, Aurélien, 38054 GRENOBLE CEDEX 09 (FR)
(74) Mandataire: Brevalex

(57) **Abrégé**

Transistor bipolaire à émission lumineuse (100), comprenant au moins :
- des première, deuxième et troisième portions de semi-conducteur dopé (102, 104, 106), formant respectivement un collecteur, une base et un émetteur du transistor bipolaire à émission lumineuse (100) ;
- au moins un puits quantique (110) disposé dans la première portion de semi-conducteur (102) et entre deux premières couches barrières (111) formées par le semi-conducteur dopé de la première portion (102),
et dans lequel les niveaux des bandes d'énergie du semi-conducteur dopé de la première portion (111) sont supérieurs à ceux d'un semi-conducteur formant le puits quantique (110) qui est configuré pour produire l'émission lumineuse du transistor bipolaire.

## Description

### DOMAINE TECHNIQUE

Le domaine technique de l'invention est celui des composants électroniques à émission lumineuse, notamment réalisés avec du GaN ou un semi-conducteur comprenant du GaN, et plus généralement tout semi-conducteur de type III-V. De tels composants sont avantageusement utilisés dans un dispositif émissif lumineux sous la forme d'une matrice, formant ainsi un écran.

### ÉTAT DE LA TECHNIQUE ANTÉRIEURE

Les composants électroniques les plus couramment utilisés pour réaliser une émission lumineuse sont les diodes électroluminescentes, ou LED. Une LED est le plus souvent associée à un circuit électronique, par exemple de type CMOS, réalisant un pilotage en courant de la LED, c'est-à-dire modulant l'émission lumineuse de la LED en faisant varier le courant envoyé à la LED.

D'autres types de composants électroniques à émission lumineuse ont été proposés, notamment dans le but de grouper au sein d'un même composant électronique l'élément réalisant une émission lumineuse avec un élément de commande.

Le document US 2008/0240173 A1 propose de réaliser un transistor bipolaire dans lequel un puits quantique, qui réalise une émission lumineuse, est intégré dans la base du transistor. Cette intégration d'un élément émissif au sein de la base d'un transistor bipolaire est avantageuse car le courant circulant dans le transistor est utilisé pour produire l'émission lumineuse. De plus, l'élément émissif et l'élément de commande sont bien intégrés au sein d'un seul composant électronique. Toutefois, la base d'un transistor bipolaire est fabriquée avec une très faible épaisseur afin de favoriser le passage des porteurs de charges entre l'émetteur et le collecteur très rapidement. En raison de cette très faible épaisseur de la base du transistor bipolaire, un seul puits quantique peut être réalisé dans la base du transistor bipolaire. Or, un nombre plus important de puits quantiques serait avantageux car cela permettrait d'améliorer le rendement émissif de ce composant.

Le document US 2010/0277466 A1 propose une solution alternative dans laquelle un ou plusieurs éléments émissifs sont intégrés dans un transistor bipolaire, ces éléments émissifs correspondant à des capacités émissives. De telles capacités émissives ne sont toutefois pas bien adaptées pour réaliser une émission lumineuse au sein d'un transistor bipolaire. En effet, un élément capacitif comporte un matériau diélectrique disposé entre deux électrodes. Une émission de lumière à partir d'un tel élément n'est possible qu'avec de très forts niveaux de courant/tension étant donné que la bande interdite du matériau diélectrique est très grande énergétiquement. De plus, le courant circulant dans le transistor, qui est un courant continu, ne peut pas traverser une capacité d'une électrode à l'autre. Seul un courant alternatif peut traverser une telle capacité. Ainsi, une émission lumineuse n'est obtenue que lorsqu'une importante décharge électrique traverse la ou les capacités intégrées au transistor. Un tel fonctionnement n'est pas optimal pour commander correctement une émission lumineuse.

Le document US 5 153 693 propose un dispositif semi-conducteur intégrant, dans un même empilement, un transistor bipolaire et une diode émissive intégrée entre le substrat de croissance et le collecteur du transistor bipolaire. Le transistor intègre en outre des couches barrières insérées dans le collecteur et servant à améliorer la bistabilité du transistor en l'absence de charge résistive externe au transistor. Ces couches barrières permettent de contrôler le flux de charges électriques dans le collecteur via le contrôle du passage des charges à travers ces couches barrières par effet tunnel résonant.

Dans ce dispositif, l'émission de lumière est obtenue par l'addition, entre le collecteur du transistor et le substrat de croissance, d'une LED ou d'un laser. Le transistor de ce dispositif n'émet pas de lumière en lui-même. Les couches barrière utilisées dans le collecteur ne sont pas dédiées à piéger les porteurs pour permettre une émission de lumière entre elles.

### EXPOSÉ DE L'INVENTION

Un but de la présente invention est de proposer un nouveau composant électronique intégrant un élément d'émission lumineuse et un élément de commande de cette émission lumineuse, dans lequel le nombre de puits quantiques ne soit pas limité par une contrainte d'épaisseur au sein du composant, et permettant d'avoir une émission lumineuse aussi efficace que celle d'une LED.

Pour cela, l'invention propose un transistor bipolaire à émission lumineuse, comprenant au moins :
- des première, deuxième et troisième portions de semi-conducteur dopé, formant respectivement un collecteur, une base et un émetteur du transistor bipolaire à émission lumineuse ;
- au moins un puits quantique disposé dans la première portion de semi-conducteur et entre deux premières couches barrières formées par le semi-conducteur dopé de la première portion.

Les niveaux des bandes d'énergie du semi-conducteur dopé de la première portion peuvent être supérieurs à ceux d'un semi-conducteur formant le puits quantique qui est configuré pour produire l'émission lumineuse du transistor bipolaire.

L'invention propose d'intégrer un puits quantique, c'est-à-dire un élément émissif similaire à une LED, dans le collecteur d'un transistor bipolaire. Ainsi, le courant qui traverse le collecteur, qui correspond au courant de base multiplié par le gain du transistor, traverse le ou les puits quantiques pour réaliser une émission lumineuse. L'émission lumineuse obtenue est donc commandée en courant par l'intermédiaire du courant de base du transistor bipolaire.

Dans le transistor selon l'invention, les couches nécessaires à l'émission de lumière sont intégrées dans la fabrication du collecteur lui-même.

Le transistor bipolaire selon l'invention forme donc bien un composant électronique intégrant un élément d'émission lumineuse et un élément de commande de cette émission lumineuse, dans lequel le courant amplifié du transistor contrôle l'émission lumineuse produite par le ou les puits quantiques.

Le collecteur d'un transistor bipolaire étant polarisé en inverse, l'intégration d'un ou plusieurs puits quantiques au sein du collecteur n'est pas une solution envisagée de manière évidente par l'homme du métier. En effet, une LED comportant un ou plusieurs puits quantiques est fonctionnelle en polarisation directe pour avoir un nombre conséquent de charges électriques injectées à faire recombiner dans le ou les puits quantiques. Néanmoins, le collecteur d'un transistor bipolaire est une zone utilisée pour accélérer et amplifier les porteurs de charges injectés par l'émetteur et qui traversent le collecteur. En disposant un ou plusieurs puits quantiques dans le collecteur, une partie des charges électriques accélérées dans le collecteur sont piégées dans le/les puits quantiques et peuvent produire des recombinaisons radiatives.

Le ou chaque puits quantique est formé par une couche de matériau semi-conducteur de plus petit gap que celui du semi-conducteur de la première portion (c'est-à-dire du collecteur) dans lequel le puits quantique est disposé.

Du fait que les premières couches barrières sont formées par le semi-conducteur dopé de la première portion, et donc ne correspondent pas à des couches d'un semi-conducteur différent de celui de la première portion et insérées dans la première portion, les épaisseurs des premières couches barrières sont donc supérieures à une épaisseur limite au-delà de laquelle des charges électriques ne peuvent pas traverser les premières couches barrières par effet tunnel résonant. Cela permet ainsi de former un puits quantique produisant une émission lumineuse à partir des charges électriques piégées dans le puits quantique.

En outre, utiliser le semi-conducteur dopé du collecteur pour former les couches barrières facilite la croissance du composant lui-même car aucun changement majeur n'intervient durant la fabrication du transistor, hormis l'insertion de la ou des couches formant les puits quantiques qui ont une bande interdite inférieure à celle du semi-conducteur dopé du collecteur.

Le transistor peut être configuré tel que :
- dans une première partie de la première portion de semi-conducteur, les niveaux des bandes d'énergie du semi-conducteur dopé de cette première partie ont des premières valeurs ;
- les niveaux des bandes d'énergie du semi-conducteur dopé de la deuxième portion de semi-conducteur ont des deuxièmes valeurs différentes des premières valeurs ;
- dans une deuxième partie de la première portion de semi-conducteur disposée entre la première partie de la première portion de semi-conducteur et la deuxième portion de semi-conducteur, les niveaux des bandes d'énergie du semi-conducteur dopé de cette deuxième partie varient en passant des premières valeurs aux deuxièmes valeurs ;
- le ou les puits quantiques sont disposés dans la deuxième partie de la première portion de semi-conducteur.

Dans cette configuration, les niveaux des bandes d'énergie du semi-conducteur de la première portion qui est juxtaposé au(x) puits quantique(s) sont supérieurs à ceux du semi-conducteur formant le(s) puits quantique(s).

Les caractéristiques ci-dessus relatives aux niveaux des bandes d'énergie des semi-conducteurs sont obtenues en l'absence de polarisation du transistor, c'est-à-dire lorsque les bandes d'énergies des matériaux ne sont pas courbées par cette polarisation.

Le transistor bipolaire à émission lumineuse peut comporter en outre une deuxième couche barrière disposée dans la deuxième partie de la première portion de semi-conducteur et telle que le ou les puits quantiques soient disposés entre la deuxième couche barrière et la deuxième portion de semi-conducteur. Cette deuxième couche barrière permet d'avoir une avalanche des porteurs dans le collecteur et d'augmenter le nombre de charges électriques piégées dans le ou les puits quantiques, et donc d'obtenir une émission lumineuse plus importante en contrepartie d'une légère baisse du gain du transistor.

Le transistor bipolaire à émission lumineuse peut comporter plusieurs puits quantiques disposés dans la première portion de semi-conducteur, chaque puits quantique pouvant être séparé d'un puits quantique voisin par au moins une couche barrière intermédiaire formée par le semi-conducteur dopé de la première portion de semi-conducteur.

Le transistor bipolaire à émission lumineuse peut être tel que :
- les première, deuxième et troisième portions de semi-conducteur comportent du GaN (avec dans ce cas les premières couches barrières et la ou les éventuelles couches barrières intermédiaires qui comportent du GaN), et le ou les puits quantiques comportent de l'InGaN, ou
- les première, deuxième et troisième portions de semi-conducteur comportent du GaAs (avec dans ce cas les premières couches barrières et la ou les éventuelles couches barrières intermédiaires qui comportent du GaAs), et le ou les puits quantiques comportent de l'InGaAs, ou
- les première, deuxième et troisième portions de semi-conducteur comportent de l'InP (avec dans ce cas les premières couches barrières et la ou les éventuelles couches barrières intermédiaires qui comportent de l'InP), et le ou les puits quantiques comportent du GalnP, ou
- les première, deuxième et troisième portions de semi-conducteur comportent de l'AIGaAs (avec dans ce cas les premières couches barrières et la ou les éventuelles couches barrières intermédiaires qui comportent de l'AIGaAs), et le ou les puits quantiques comportent de l'InAlGaAs.

L'utilisation de GaN pour former les première, deuxième et troisième portions permet d'obtenir un transistor adapté pour fonctionner avec des puissances importantes. En outre, lorsque les première, deuxième et troisième portions comportent du GaN et que le ou les puits quantiques comportent de l'InGaN, l'émission lumineuse obtenue peut correspondre à une émission lumineuse bleue ou verte ou violette en fonction du taux, ou de la concentration, d'indium dans l'InGaN du ou des puits quantiques, voire une émission lumineuse dans le domaine ultraviolet lorsque le taux, ou la concentration, d'indium est faible dans l'InGaN du ou des puits quantiques (par exemple inférieur à environ 5 %).

L'utilisation de GaAs ou d'InP pour former les première, deuxième et troisième portions et d'InGaAs ou de GalnP pour former le ou les puits quantiques permet d'obtenir une émission lumineuse dans le domaine infrarouge.

L'utilisation d'AIGaAs pour former les première, deuxième et troisième portions et d'InAlGaAs pour former le ou les puits quantiques permet d'obtenir une émission lumineuse de couleur rouge.

La composition atomique du semi-conducteur dopé de la première portion de semi-conducteur peut être différente de celle du semi-conducteur dopé de la deuxième portion et/ou de la troisième portion de semi-conducteur. Cette configuration permet de réaliser un transistor bipolaire à hétérojonction. Le semi-conducteur de la première portion, dans lequel le ou les puits quantiques sont intégrés, peut être choisi indépendamment de celui utilisé pour former les deuxième et troisième portions. Il est ainsi possible d'optimiser le gain et/ou l'émission lumineuse réalisée par le transistor.

L'invention concerne également un dispositif émissif lumineux comprenant :
- au moins un transistor bipolaire à émission lumineuse tel que décrit ci-dessus,
- au moins un circuit de polarisation du ou des transistors bipolaires à émission lumineuse, configuré pour polariser le ou les transistors bipolaires à émission lumineuse en émetteur commun.

Ce dispositif peut comporter une matrice de transistors bipolaires à émission lumineuse formant un écran.

L'invention concerne également un procédé de réalisation d'un transistor bipolaire à émission lumineuse tel que décrit ci-dessus, dans lequel les première, deuxième et troisième portions de semi-conducteur et le ou les puits quantiques sont réalisés par la mise en œuvre d'étapes d'épitaxie et de dopage.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un transistor bipolaire comprenant un élément d'émission lumineuse intégré, objet de la présente invention, selon un mode de réalisation particulier ;
- la figure 2 représente schématiquement un exemple de réalisation particulier d'un transistor bipolaire comprenant un élément d'émission lumineuse intégré ;
- la figure 3 représente les courants i_{B} et i_{C} et le taux de recombinaisons radiatives obtenus dans un transistor bipolaire à émission lumineuse selon l'invention, en fonction de la valeur d'un potentiel électrique appliquée sur la base du transistor ;
- la figure 4 représente le gain obtenu dans un transistor bipolaire à émission lumineuse selon l'invention, c'est-à-dire la valeur du courant de collecteur ic en fonction de la valeur du courant de base i_{B} ;
- la figure 5 représente le taux de recombinaisons radiatives obtenu dans un transistor bipolaire à émission lumineuse selon l'invention, en fonction de la valeur du courant de base i_{B} ;
- la figure 6 représente le spectre d'émission obtenu dans un transistor bipolaire à émission lumineuse selon l'invention ;
- la figure 7 représente les bandes d'énergie au sein des première et deuxième portions de semi-conducteur du transistor bipolaire à émission lumineuse selon l'invention, en présence de la deuxième couche barrière ;
- la figure 8 représente les bandes d'énergie au sein des première et deuxième portions de semi-conducteur du transistor bipolaire à émission lumineuse selon l'invention, en l'absence de deuxième couche barrière ;
- la figure 9 représente le gain obtenu dans un transistor bipolaire à émission lumineuse selon l'invention, c'est-à-dire la valeur du courant de collecteur ic en fonction de la valeur du courant de base i_{B}, avec et sans couche barrière interposée entre les puits quantiques et le collecteur du transistor ;
- la figure 10 représente le taux de recombinaisons radiatives obtenu dans un transistor bipolaire à émission lumineuse selon l'invention, en fonction de la valeur du courant de base i_{B}, avec et sans couche barrière interposée entre les puits quantiques et le collecteur du transistor ;
- la figure 11 représente schématiquement un dispositif émissif lumineux, objet de la présente invention, comportant une matrice de transistors bipolaires à émission lumineuse ;
- les figures 12 à 22 représentent les étapes d'un procédé de réalisation d'un transistor bipolaire à émission lumineuse, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

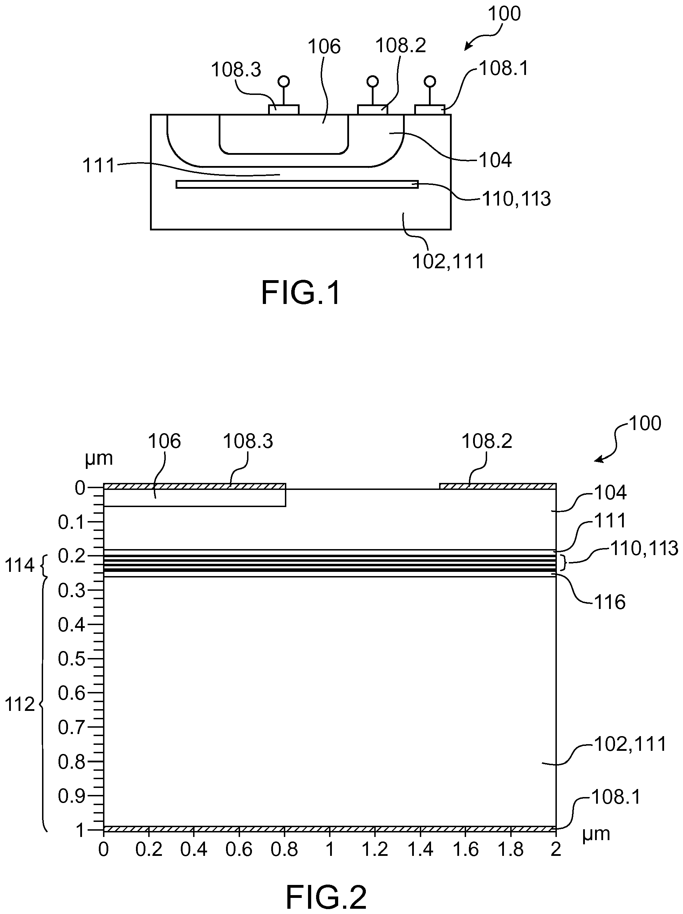

Un transistor bipolaire à émission lumineuse 100 réalisé selon un mode de réalisation particulier est décrit ci-dessous en lien avec les figures 1 et 2 qui représentent schématiquement le principe d'un tel transistor.

Le transistor 100 comporte une première portion de semi-conducteur 102 formant le collecteur du transistor 100. Lorsque le transistor 100 est de type npn, le semi-conducteur de cette première portion 102 est dopé n, et lorsque le transistor 100 est de type pnp, le semi-conducteur de cette première portion 102 est dopé p. Le niveau de dopage de cette première portion 102 est par exemple compris entre environ 5.10¹⁷ cm⁻³ et 1.10¹⁸ cm⁻³. L'épaisseur de la première portion 102 est par exemple comprise entre environ 300 nm et 1000 nm.

Le transistor 100 comporte une deuxième portion de semi-conducteur 104 disposée contre la première portion 102 et formant la base du transistor 100. Lorsque le transistor 100 est de type npn, le semi-conducteur de cette deuxième portion 104 est dopé p, et lorsque le transistor 100 est de type pnp, le semi-conducteur de cette deuxième portion 104 est dopé n. Le niveau de dopage de cette deuxième portion 104 est par exemple compris entre environ 1.10¹⁸ cm⁻³ et 5.10¹⁸ cm⁻³. L'épaisseur de la deuxième portion 104 est par exemple comprise entre environ 100 nm et 200 nm.

Le transistor 100 comporte une troisième portion de semi-conducteur 106 disposée contre la deuxième portion 104 et séparée de la première portion 102 par la deuxième portion 104. La troisième portion 106 forme l'émetteur du transistor 100. Lorsque le transistor 100 est de type npn, le semi-conducteur de cette troisième portion 106 est dopé n, et lorsque le transistor 100 est de type pnp, le semi-conducteur de cette troisième portion 106 est dopé p. Le niveau de dopage de cette troisième portion 106 est par exemple compris entre environ 1.10¹⁹ cm⁻³ et 5.10¹⁹ cm⁻³. L'épaisseur de la troisième portion 106 est par exemple comprise entre environ 50 nm et 100 nm.

Dans le mode de réalisation particulier décrit ici, le transistor 100 est à transistor à homojonction.

Le semi-conducteur des portions 102, 104, 106 est de type III-V, c'est-à-dire comprend un ou plusieurs éléments de la colonne III et un ou plusieurs éléments de la colonne V du tableau périodique des éléments. Avantageusement, le semi-conducteur des portions 102, 104 et 106 est du GaN. En variante, ce semi-conducteur peut être du GaAs, de l'InP ou encore de l'AIGaAs. D'autres semi-conducteurs peuvent toutefois être utilisés pour réaliser ces portions 102, 104, 106, en fonction des propriétés souhaitées pour le transistor 100.

Le transistor 100 comporte trois contacts 108.1-108.3 chacun disposé contre l'une des trois portions 102, 104 et 106 et formant des accès électriques à ces portions 102, 104, 106. Les contacts 108.1-108.3 comportent chacun un matériau électriquement conducteur. Sur la représentation schématique de la figure 1, les trois contacts 108.1-108.3 sont disposés sur la face avant du transistor 100. Sur la figure 2, le premier contact 108.1 relié au collecteur du transistor 100 se trouve en face arrière du transistor 100 et les deuxième et troisième contacts 108.2, 108.3 reliés à la base et à l'émetteur du transistor 100 se trouvent en face avant du transistor 100.

Le transistor 100 comporte en outre un élément d'émission lumineuse comprenant un ou plusieurs puits quantiques 110 réalisés au sein de la première portion 102, c'est-à-dire au sein du collecteur du transistor 100. Ce ou ces puits quantiques 110 sont formés par une ou plusieurs couches de semi-conducteur dont le gap est inférieur à celui du semi-conducteur de la première portion 102. Par exemple, lorsque la première portion 102 comporte du GaN, le ou les puits quantiques 110 correspondent par exemple à une ou plusieurs couches d'InGaN. Lorsque la première portion 102 comporte du GaAs, le ou les puits quantiques 110 comportent par exemple de l'InGaAs. Lorsque la première portion 102 comporte de l'InP, le ou les puits quantiques 110 comportent par exemple du GaInP. Lorsque la première portion 102 comporte de l'AIGaAs, le ou les puits quantiques 110 comportent par exemple de l'InAlGaAs.

Chaque couche de semi-conducteur formant un puits quantique 110 a une épaisseur par exemple comprise entre environ 2 nm et 4 nm.

Dans le mode de réalisation décrit ici, le transistor 100 comporte trois puits quantiques 110. De manière générale, le transistor 100 comporte un nombre de puits quantiques compris entre environ 1 et 5.

Le puits quantique 110, ou l'ensemble formé par les puits quantiques 110, est disposé entre deux premières couches barrières 111 formées par le semi-conducteur dopé de la première portion 102, et plus précisément par l'ensemble du semi-conducteur dopé de la première portion 102 se trouvant de chaque côté du puits quantique 110 ou de chaque côté de l'ensemble formé par les puits quantiques 110. Par exemple, lorsque la première portion 102 comporte du GaN et que le ou les puits quantiques 110 correspondent par exemple à une ou plusieurs couches d'InGaN, les deux premières couches barrières 111 sont formées par tout le GaN de la première portion 102 se trouvant de chaque côté du puits quantique 110 ou de l'ensemble formé par les puits quantiques 110. Lorsque la première portion 102 comporte du GaAs et que le ou les puits quantiques 110 comportent par exemple de l'InGaAs, les deux premières couches barrières 111 sont formées par tout le GaAs de la première portion 102 se trouvant de chaque côté du puits quantique 110 ou de l'ensemble formé par les puits quantiques 110. Lorsque la première portion 102 comporte de l'InP et que le ou les puits quantiques 110 comportent par exemple du GalnP, les deux premières couches barrières 111 sont formées par tout l'InP de la première portion 102 se trouvant de chaque côté du puits quantique 110 ou de l'ensemble formé par les puits quantiques 110. Lorsque la première portion 102 comporte de l'AIGaAs et que le ou les puits quantiques 110 comportent par exemple de l'InAlGaAs, les deux premières couches barrières 111 sont formées par tout l'AIGaAs de la première portion 102 se trouvant de chaque côté du puits quantique 110 ou de l'ensemble formé par les puits quantiques 110.

Du fait que les premières couches barrières 111 sont formées par le semi-conducteur dopé de la première portion, les épaisseurs des premières couches barrières 111 sont donc supérieures à une épaisseur limite au-delà de laquelle des charges électriques ne peuvent pas traverser les premières couches barrières par effet tunnel résonant, cette épaisseur limite étant par exemple égale à 10 nm.

De manière générale, l'épaisseur de chacune des deux premières couches barrières 111 entre lesquelles se trouve le puits quantique 110 ou l'ensemble des puits quantiques 110 est égale à plusieurs dizaines de nanomètres (par exemple au moins 20 nm), voire une ou plusieurs centaines de nanomètres (par exemple au moins 100 nm). Ainsi, les charges piégées dans le puits quantique 110 ou l'un des puits quantiques 110 ne peuvent pas traverser les premières couches barrières 111.

Lorsque le transistor 100 comporte plusieurs puits quantiques 100, deux puits quantiques voisins sont espacés l'un de l'autre par une couche barrière intermédiaire 113 dont l'épaisseur est inférieure à celle de l'une des deux premières couches barrières 111, et par exemple inférieure à environ 20 nm voire inférieure à environ 10 nm.

Les semi-conducteurs de la première portion 102 et du ou des puits quantiques 110 sont tels qu'ils comportent au moins un élément de la colonne III et au moins un élément de la colonne V en commun.

Le ou les puits quantiques 110 sont disposés dans une partie du collecteur du transistor 100 se trouvant à proximité de la base du transistor 100. En effet, étant donné la jonction p-n formée par la base et le collecteur du transistor 100, le collecteur est formé de deux parties :
- une première partie 112 dans laquelle les niveaux des bandes d'énergie du semi-conducteur ont des premières valeurs ;
- une deuxième partie 114 disposée entre la première partie 112 et la base du transistor 100, dans laquelle les niveaux des bandes d'énergie du semi-conducteur de cette deuxième partie varient en passant des premières valeurs à des deuxièmes valeurs différentes des premières valeurs et qui correspondent à celles des niveaux des bandes d'énergies du semi-conducteur dans la base du transistor 100.

Le ou les puits quantiques 110 sont disposés dans cette deuxième partie 114 de la première portion 102 qui forme la zone de charge d'espace où le champ électrique est intense et draine les porteurs de charge qui pourront donc être piégés dans les puits quantiques et se recombiner pour émettre de la lumière.

De manière générale, la localisation du ou des puits quantiques 110 dans une partie du collecteur du transistor 100 se trouvant à proximité de la base du transistor 100 signifie que l'épaisseur de semi-conducteur dopé de la première portion 102 se trouvant d'un première côté du ou des puits quantiques, entre la base du transistor 100 et le ou les puits quantiques 110, est inférieure à celle du semi-conducteur dopé de la première portion 102 se trouvant d'un deuxième côté opposé au premier côté, c'est-à-dire de l'autre côté du ou des puits quantiques 110.

Dans le mode de réalisation particulier décrit ici, le transistor 100 comporte en outre une deuxième couche barrière 116. Cette deuxième couche barrière 116 est disposée dans la deuxième partie 114 de la première portion 102 et est telle que le ou les puits quantiques 110 soient disposés entre la deuxième couche barrière 116 et la deuxième portion 104. Le semi-conducteur de la deuxième couche barrière 116 a un gap plus grand que celui du semi-conducteur de la deuxième portion 104. Par exemple, lorsque la deuxième portion 104 comporte du GaN, la deuxième couche barrière 116 comporte de l'AIGaN. Cette deuxième couche barrière 116 limite la fuite des porteurs de charges du collecteur et permet d'augmenter le nombre de charges électriques piégées dans les puits quantiques 110, et donc d'obtenir une émission lumineuse plus importante, avec en contrepartie d'une légère baisse du gain β, ou h₂₁, du transistor.

Le transistor 100 est par exemple utilisé dans un dispositif polarisant le transistor 100 en émetteur commun. Dans un tel montage, la valeur du courant ic traversant le collecteur du transistor 100 est égale à celle du courant i_{B} circulant dans la base du transistor 100 multipliée par le gain β du transistor 100. Or, l'émission lumineuse réalisée par le ou les puits quantiques 110 dépend de la valeur du courant ic. Il est donc possible de contrôler cette émission lumineuse en contrôlant le courant i_{B}.

La figure 2 représente la structure du transistor 100 utilisée pour réaliser des simulations décrites ci-dessous. Les caractéristiques de ce transistor 100 modélisé sont :
- transistor 100 de type npn ;
- portions 102, 104 et 106 comportant du GaN ;
- dopage de la première portion 102 égal à environ 8.10¹⁷ cm⁻³ ;
- dopage de la deuxième portion 104 égal à environ 1.10¹⁸ cm⁻³ ;
- dopage de la troisième portion 106 égal à environ 4.10¹⁹ cm⁻³;
- épaisseur de la première portion 102 égale à environ 800 nm ;
- épaisseur de la troisième portion 106 égale à environ 50 nm ;
- épaisseur de la deuxième portion 104 égale à environ 200 nm ;
- épaisseur totale du transistor 100 égale à environ 1 µm ;
- trois puits quantiques 110 comprenant chacun une couche d'In_{0,1}Ga_{0,9}N d'épaisseur égale à environ 2 nm, les puits quantiques 110 étant séparés les uns des autres par des couches barrières intermédiaires 113 de GaN dopé d'épaisseur égale à environ 5 nm ;
- deux premières couches barrières 111 formé par le semi-conducteur de la première portion 102 (GaN dopé) se trouvant de chaque côté de l'ensemble comprenant les puits quantiques 110 et les couches barrières intermédiaires 113 disposées entre les puits quantiques, l'épaisseur de chacune de ces deux premières couches barrières 111 étant égale à plusieurs dizaines ou plusieurs centaines de nm ;
- deuxième couche barrière 116 comportant de l'AIGaN, une épaisseur égale à environ 12 nm, et le même dopage que celui du semi-conducteur de la première portion 102.

Dans la notation In_{X}Ga_{1-X}N utilisée ci-dessus, X représente la composition en indium, ou concentration en indium, du matériau, c'est-à-dire la proportion d'indium par rapport à la quantité totale d'indium et de gallium dans l'In_{X}Ga_{1-X}N.

Une simulation du comportement électrique de ce transistor 100 est réalisée en le polarisant en mode émetteur commun, en appliquant un premier potentiel électrique V_{E} = 0V sur l'émetteur, un deuxième potentiel électrique V_{C}= 5V sur le collecteur, et en faisant varier un troisième potentiel électrique V_{B} appliqué sur la base entre 0 V et 3,2 V.

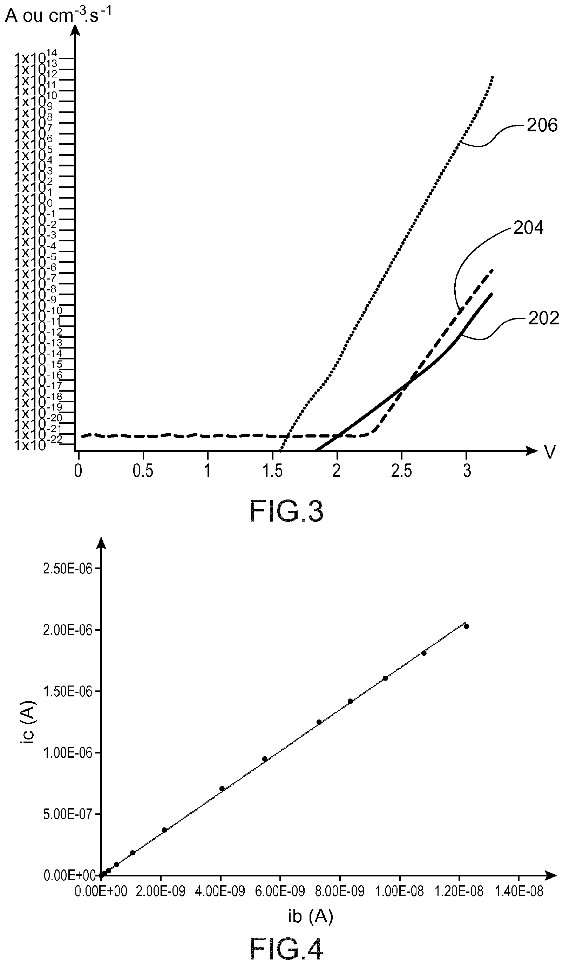

La figure 3 représente le courant de base i_{B} (courbe 202), le courant de collecteur i_{C} (courbe 204) et le taux de recombinaisons radiatives (courbe 206) obtenus lors de cette simulation. Les courbes 202 et 204 représentées sur la figure 3 montrent que dans une telle configuration, le transistor 100 réalise une amplification de courant (le courant ic devient supérieur au courant i_{B}) lorsque le troisième potentiel électrique V_{B} est supérieur ou égal à environ 2,5 V. De plus, la courbe 206 montre que le taux de recombinaisons radiatives obtenu dans les puits quantiques 110 de ce transistor 100 commence à être significatif lorsque V_{B} est supérieur ou égal à environ 2,5 V, et augmente en fonction du courant i_{B} injecté dans le transistor 100.

La figure 4 représente le gain β du transistor 100 modélisé, correspondant au rapport i_{C}/i_{B}, obtenu dans les conditions de polarisation indiquées ci-dessus.

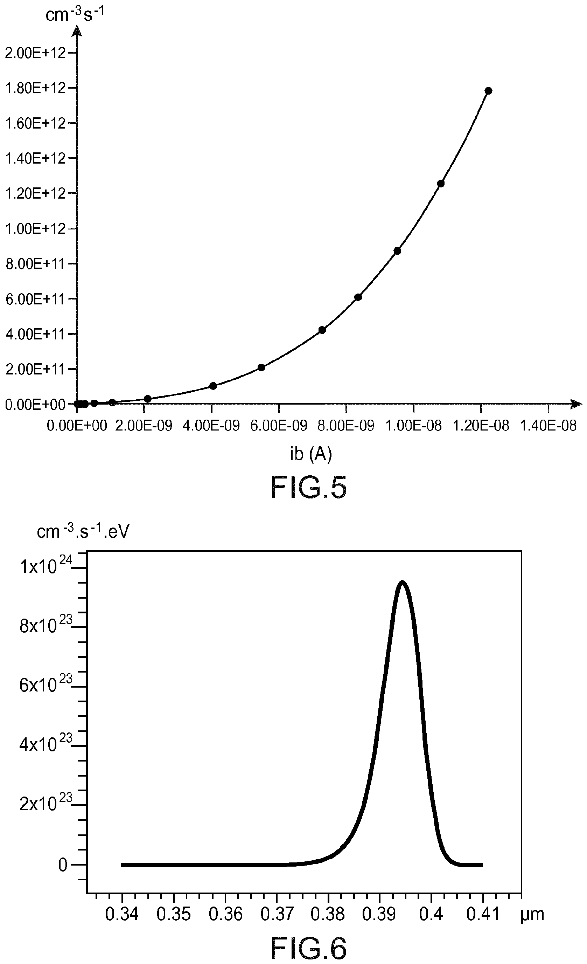

La figure 5 représente le taux de recombinaisons radiatives obtenu en faisant varier la valeur du courant i_{B}.

Les courbes des figures 3 à 5 montrent donc bien que :
- la fonction d'amplification remplie par le transistor 100 n'est pas altérée par la présence des puits quantiques 110, et que
- l'émission lumineuse est commandée en courant en fonction du courant i_{B} injecté dans le transistor 100.

Le spectre d'émission du transistor 100 selon cet exemple de réalisation particulier est représenté sur la figure 6. Cette figure montre que la lumière émise depuis les puits quantiques 110 a un spectre centré autour d'une fréquence égale à environ 395 nm (lumière de couleur violette). La fréquence centrale du spectre de la lumière émise par les puits quantiques 110 dépend notamment du taux d'indium dans le semi-conducteur des puits quantiques 110. Une optimisation du taux d'indium et du placement des puits quantiques 110 peut être réalisée pour avoir une émission d'une couleur particulière dans le domaine visible (exemple bleu, vert, violet ou rouge). Par exemple, pour émettre une lumière verte ou bleue ou violette, le semi-conducteur des puits quantiques 110 est avantageusement de l'InGaN. Pour émettre dans le domaine ultraviolet, le taux d'indium de l'InGaN est choisi inférieur ou égal à environ 5 %. Pour émettre une lumière de couleur rouge, le semi-conducteur des puits quantiques 110 est par exemple de l'InAlGaAs. Pour émettre dans le domaine infrarouge, le semi-conducteur des puits quantiques 110 est par exemple de l'InGaAs ou du GalnP.

Dans le mode de réalisation particulier décrit ci-dessus, le transistor 100 comporte la deuxième couche barrière 116 permettant de limiter la fuite des porteurs de charges dans le collecteur du transistor 100. Selon une variante de réalisation, le transistor 100 peut ne pas comporter de deuxième couche barrière 116.

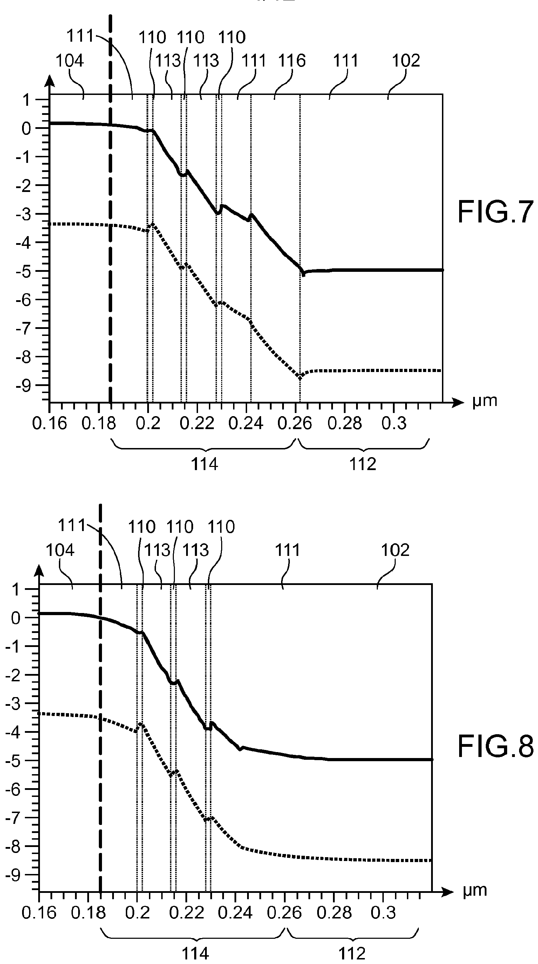

La figure 7 représente les bandes d'énergies au sein du transistor 100 en présence de la deuxième couche barrière 116, tandis que la figure 8 représente les bandes d'énergies au sein du transistor 100 en l'absence de la deuxième couche barrière 116. Sur ces deux figures, les références utilisées précédemment pour désigner les différents éléments du transistor 100 sont reportées sur les figures 7 et 8 pour désigner niveaux des bandes d'énergies dans ces différents éléments.

Les figures 7 et 8 illustrent également la distinction réalisée dans la première portion 102 entre la première partie 112 dans laquelle les niveaux des bandes d'énergie du semi-conducteur ont des premières valeurs, et la deuxième partie 114 dans laquelle les niveaux des bandes d'énergie du semi-conducteur varient en passant des premières valeurs aux deuxièmes valeurs qui correspondent à celles des niveaux des bandes d'énergies du semi-conducteur dans la deuxième portion 104.

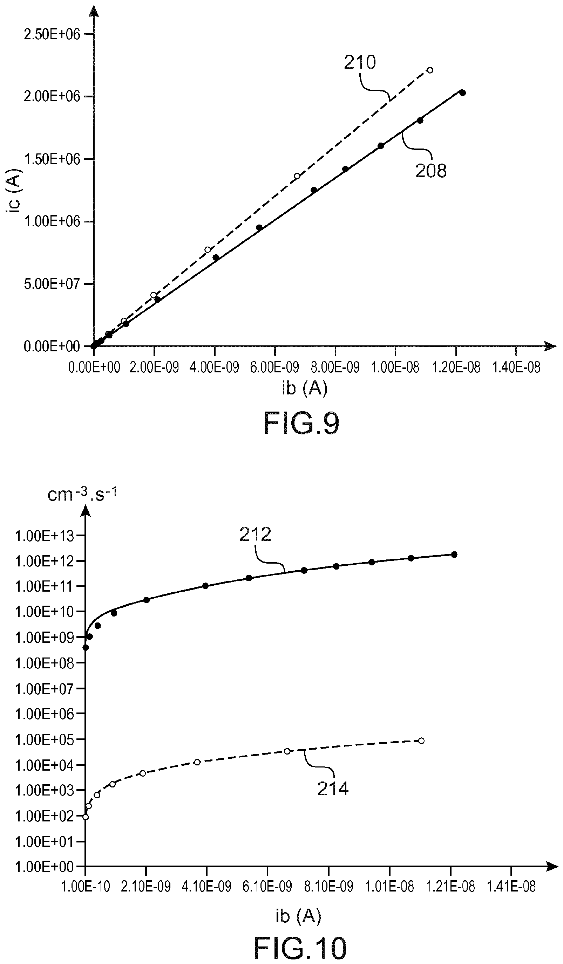

La figure 9 représente le gain du transistor 100 obtenu avec la deuxième couche barrière 116 (courbe 208) et sans la deuxième couche barrière 116 (courbe 210). La figure 10 représente le taux de recombinaisons radiatives obtenu dans les puits quantiques 110 du transistor 100 avec la deuxième couche barrière 116 (courbe 212) et sans la deuxième couche barrière 116 (courbe 214).

Lorsque le transistor 100 ne comporte pas la deuxième couche barrière 116, une plus grande amplification du courant est obtenue, le gain β étant égal à environ 200. Par contre, l'émission lumineuse obtenue dans ce cas est plus faible, en raison de la baisse du taux de recombinaisons radiatives dans les puits quantiques 110. Cela s'explique du fait qu'en l'absence de cette deuxième couche barrière 116, les porteurs de charges sont plus attirés du côté du contact du collecteur du transistor 100 et donc qu'une plus faible quantité de porteurs de charges se recombinent dans les puits quantiques 110. Ainsi, l'épaisseur et la position de la deuxième couche barrière 116 au sein de la première portion 102 correspondent à deux variables permettant d'ajuster le gain du transistor 100 et l'intensité d'émission lumineuse du transistor 100.

Dans le mode de réalisation particulier décrit ci-dessus, le transistor 100 est à homojonction, le matériau semi-conducteur du collecteur (première portion 102) étant similaire à celui de la base et de l'émetteur (deuxième et troisième portions 104 et 106). En variante, il est possible que le transistor 100 soit un transistor à hétérojonction, le matériau semi-conducteur du collecteur étant alors différent de celui de la base et/ou de l'émetteur. Un tel transistor à hétérojonction comporte par exemple un émetteur comprenant de l'AIGaN, une base comprenant de l'AIGaN et un collecteur comprenant du GaN.

Le transistor 100 décrit ci-dessus peut être utilisé comme une LED, en injectant un courant dans la base du transistor 100 pour piloter son émission lumineuse.

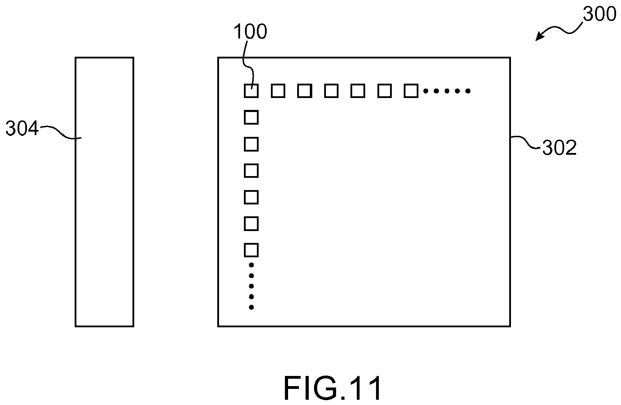

La figure 11 représente schématiquement un dispositif émissif lumineux 300 comportant une matrice 302 de transistors bipolaires à émission lumineuse 100. Cette matrice 302 forme un écran. Le dispositif 300 comporte également un circuit 304 de polarisation des transistors 100 configuré pour polariser les transistors 100 en émetteur commun.

Le transistor 100 décrit précédemment est réalisé en mettant en œuvre des étapes d'épitaxie pour former les première, deuxième et troisième portions de semi-conducteur et le ou les puits quantiques.

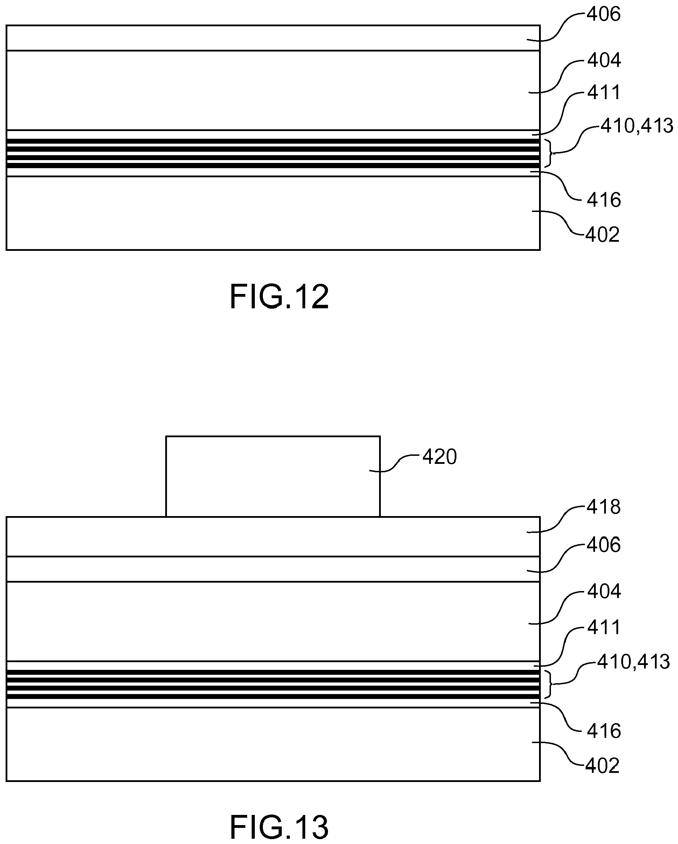

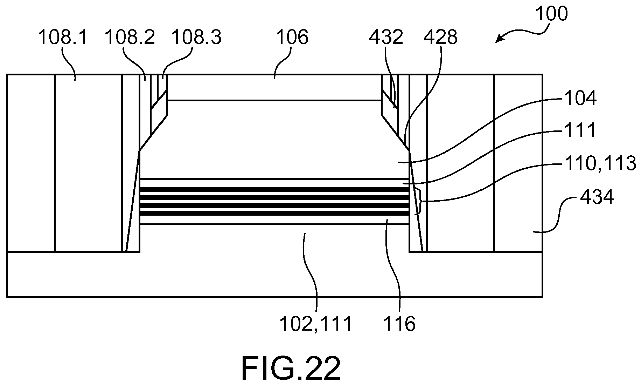

Un procédé de réalisation du transistor 100 selon un mode de réalisation particulier est décrit ci-dessous en lien avec les figures 12 à 22. Le transistor 100 réalisé selon ce procédé est par exemple destiné à servir de micro-pixel au sein d'une matrice de transistors 100 formant un écran.

Le transistor 100 est par exemple réalisé à partir d'un substrat comprenant une couche de GaN disposée sur une couche support de semi-conducteur (substrat), par exemple du silicium ou du saphir. Les différentes couches servant à former les première, deuxième et troisième portions 102, 104, 106 des transistors 100, ainsi que les puits quantiques 110 et l'éventuelle deuxième couche barrière 116, sont réalisées sur ce substrat, par exemple par épitaxie telle qu'un dépôt MOCVD (« Metallo-Organic Chemical Vapor Déposition » en anglais, et correspondant à une épitaxie en phase vapeur aux organométalliques). Les différents dopages N et P des portions 102, 104, 106 peuvent être réalisés de manière *in-situ* lors du dépôt de ces matériaux. La figure 12 représente les différentes couches ainsi formées :
- couche 402 destinée à former le collecteur des transistors 100 et l'une des deux premières couches barrières 111,
- couche 416 disposée sur la couche 402 et destinée à former la deuxième couche barrière 116 des transistors 100,
- empilement alterné de couches 410 et 413 disposé sur la couche 416 (ou sur la couche 402 en l'absence de couche 416) et destiné à former les puits quantiques 110 et les couches barrières intermédiaires 113 des transistors 100,
- couche 411 destinée à former l'autre des deux premières couches barrières 111,
- couche 404 destinée à former la base des transistors 100,
- couche 406 destinée à former l'émetteur des transistors 100.

Les caractéristiques de ces couches (épaisseurs, dopages) correspondent à celles souhaitées pour les différentes portions et les différents éléments des transistors 100.

À partir de l'empilement de couches réalisé, des étapes de gravure sont ensuite mises en œuvre pour former les contacts 108.1-108.3. Ces gravures sont réalisées à des niveaux différents pour pouvoir prendre des contacts séparés sur l'émetteur, la base et le collecteur des transistors 100. Un exemple de réalisation permettant de former de tels contacts est décrit ci-dessous (d'autres techniques sont toutefois possibles pour former ces contacts).

Une couche 418 destiné à former un masque dur et comprenant par exemple du SiN et/ou du SiO₂ est déposé sur la couche 406.

Une résine photosensible est ensuite déposée sur la couche 418. Une étape de photolithographie est ensuite mise en œuvre pour que des portions restantes 420 de résine forment le motif du masque dur destiné à définir les différentes portions de matériau de chacun des transistors 100 (étape de singularisation des transistors 100). La structure obtenue à ce stade du procédé est représentée sur la figure 13.

La couche 418 est ensuite gravée de manière anisotrope selon le motif défini par les portions restantes 420 de résine, les portions restantes de cette couche 418 formant le masque dur 422.

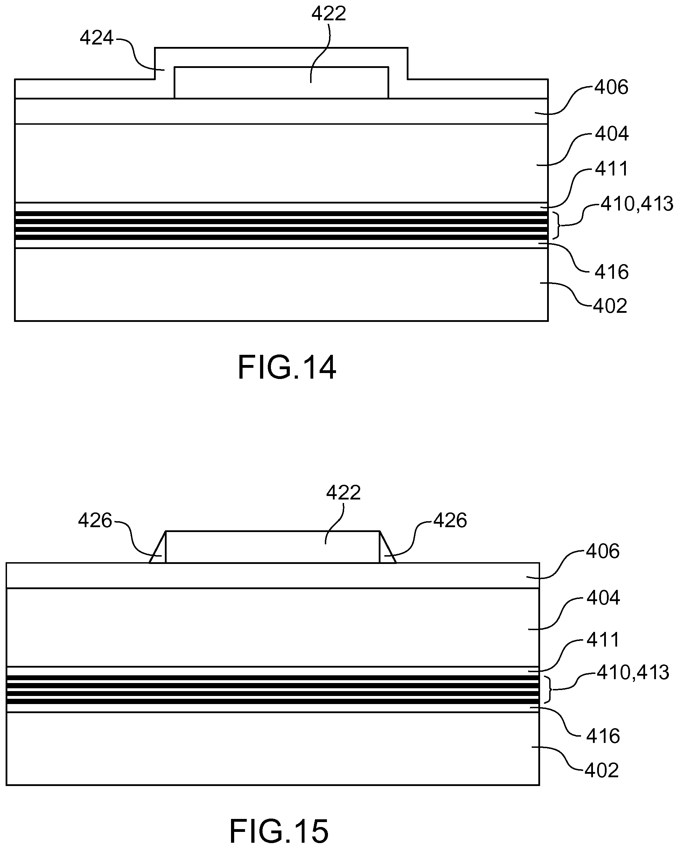

Les portions restantes 420 de résine sont ensuite retirées. Une couche 424 destinée à former des espaceurs contre les flancs latéraux du masque dur 422 est ensuite déposée par une technique de dépôt conforme, par exemple par CVD (dépôt chimique en phase vapeur) tel qu'un dépôt PECVD (dépôt chimique en phase vapeur assisté par plasma), ALD (dépôt de couche atomique), etc. La structure obtenue à ce stade du procédé est représentée sur la figure 14.

Une gravure anisotrope de la couche 424 est ensuite mise en œuvre sélectivement par rapport au matériaux présents sous cette couche, c'est-à-dire par rapport aux matériaux des couches 402, 416, 410, 413, 411, 404 et 406, et par rapport au masque dur 422, formant des espaceurs 426 contre les flancs latéraux du masque dur 422 (voir figure 15).

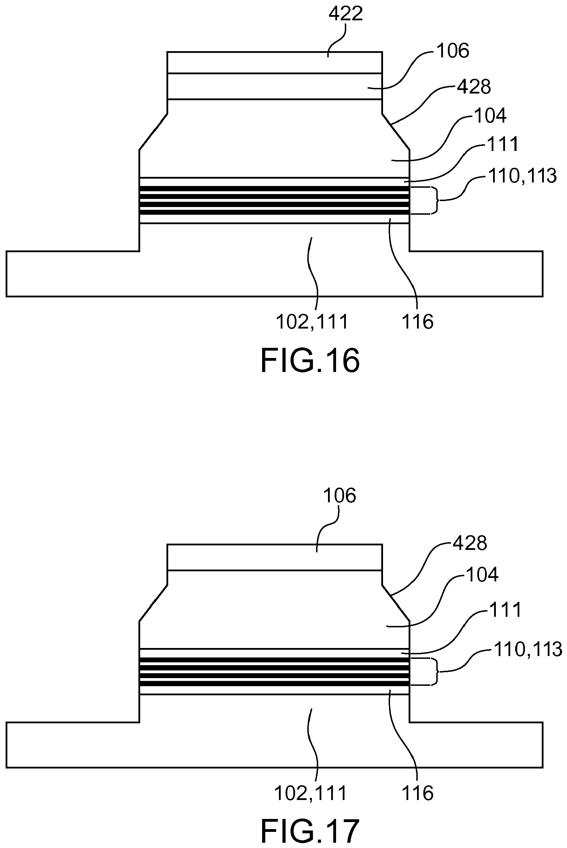

Une gravure anisotrope est ensuite mise en œuvre afin de former, à partir couches présentes, des empilements de portions formant chacun un transistor 100. Les espaceurs 426 sont consommés au fur et à mesure, formant les portions 102, 104, 106, 110, 111 et 116 sous la forme d'un empilement (représenté sur la figure 16) comprenant un épaulement 428 formé au niveau de la base (deuxième portion 104) du transistor 100 qui permettra par la suite de former le contact électrique 108.2 de la base. L'épaisseur des espaceurs 426 est optimisée pour permettre de créer cet épaulement 428 dans la deuxième portion 104.

Les portions restantes du masque dur 422 sont ensuite retirées (voir figure 17).

Une autre méthode pour obtenir le profil représenté sur la figure 17 consiste à mettre en œuvre successivement deux étapes de photolithographie, gravure et stripping (retrait du masque dur). Dans ce cas, il convient d'aligner correctement les deux niveaux de photolithographie et d'avoir une résine suffisamment épaisse pour couvrir la marche obtenue lors de la première gravure (matériau émetteur et arrêt dans la base).

Pour réaliser les contacts électriques du transistor 100, il convient d'isoler électriquement les zones de contact de l'émetteur et de la base.

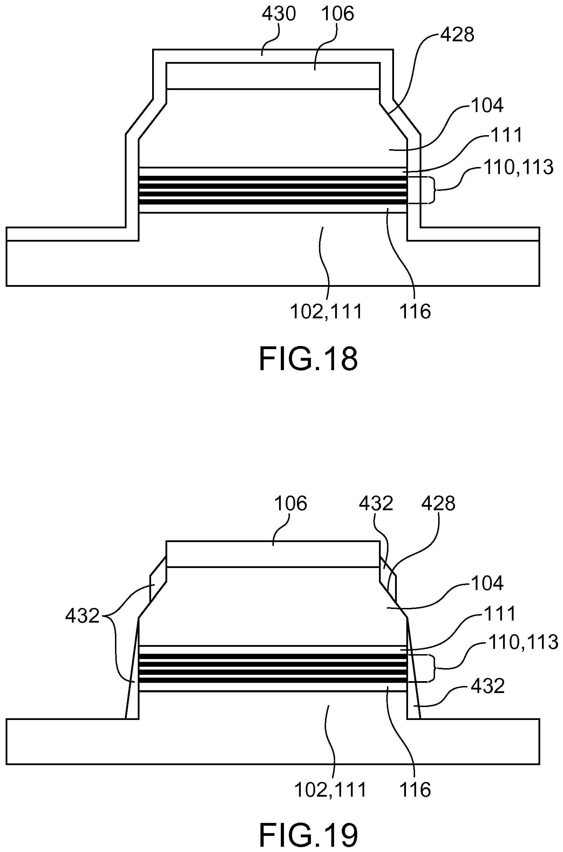

Pour cela, une couche 430 de matériau diélectrique (par exemple de l'Al₂O₃, du SiN, du SiO₂, etc.) destinée à isoler les contacts de l'émetteur et de la base du transistor 100 est déposée (voir figure 18). Le matériau de la couche 430 est choisi tel que la permittivité diélectrique et la tension de claquage de ce matériau soit compatible avec les distances entre les contacts et la tension d'utilisation. Cette couche 430 est formée par un dépôt conforme par exemple par CVD tel qu'un dépôt PECVD ou ALD.

Une gravure anisotrope du matériau diélectrique de la couche 430 est ensuite mise en œuvre. Seul des espaceurs 432, correspondant à des portions restantes de cette couche 430, sont conservés sur les flancs latéraux de l'empilement, permettant d'isoler la base vis-à-vis de l'émetteur du transistor 100 (voir figure 19). Le profil de l'épaulement 428 est formé avec une pente permettant la conservation du matériau diélectrique de la couche 430 pour former les espaceurs 432.

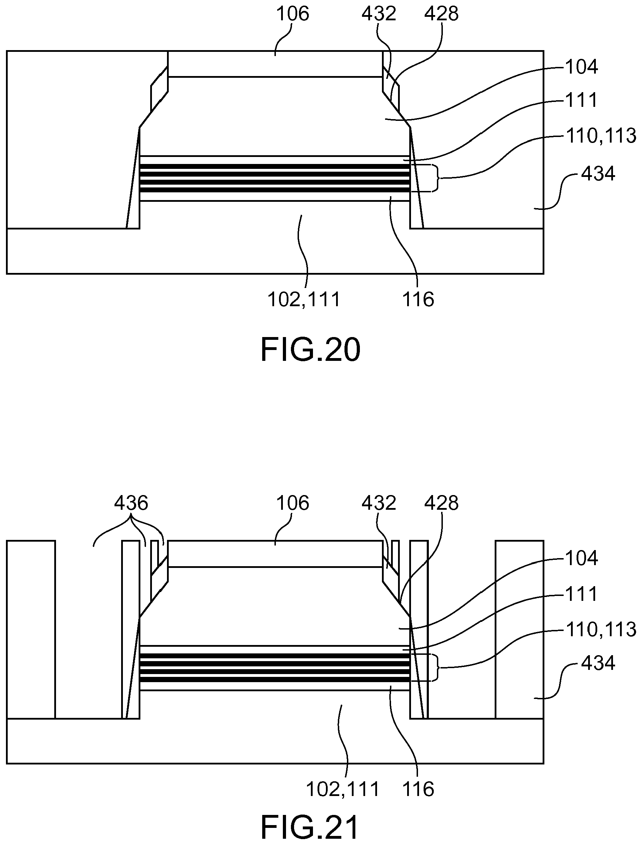

Une couche diélectrique 434, comprenant par exemple du SiO₂, est ensuite déposée sur l'ensemble de la structure réalisée. Une planarisation mécano-chimique (CMP) est ensuite mise en œuvre afin de former un accès à la surface supérieure de la troisième portion 106 (voir figure 20).

Des étapes de photolithographie et de gravure sont ensuite mises en œuvre pour réaliser les reprises de contact sur l'émetteur, la base et le collecteur du transistor 100. Le matériau diélectrique de la couche 434 est gravé sélectivement vis-à-vis du ou des semi-conducteurs présents dans l'empilement réalisé, formant à travers la couche 434 des accès 436 aux portions 102, 104 et 106. La résine utilisée pour la photolithographie est ensuite supprimée (voir figure 21).

Les contacts 108.1, 108.2 et 108.3 sont ensuite formés en déposant un ou plusieurs matériaux électriquement conducteurs, ici du métal, dans les accès 436. Selon un exemple de réalisation, ces contacts 108 sont formés en déposant tout d'abord, par dépôt CVD, une couche de TiN et si nécessaire une couche de Cu. Une électrolyse de Cu ou W est ensuite mise en œuvre pour remplir le volume restant dans les accès 436. Une CMP est ensuite mise en œuvre pour supprimer le Cu ou W dépassant des accès 436. Enfin, le TiN est gravé.

Un premier niveau de routage peut être réalisé avec ces étapes (par exemple la mise en commun des émetteurs des différents transistors) lors de la photolithographie et de la gravure de la couche diélectrique 434.

## Revendications

1. Transistor bipolaire à émission lumineuse (100), comprenant au moins :
- des première, deuxième et troisième portions de semi-conducteur dopé (102, 104, 106), formant respectivement un collecteur, une base et un émetteur du transistor bipolaire à émission lumineuse (100) ;
- au moins un puits quantique (110) disposé dans la première portion de semi-conducteur (102) et entre deux premières couches barrières (111) formées par le semi-conducteur dopé de la première portion (102),
et dans lequel les niveaux des bandes d'énergie du semi-conducteur dopé de la première portion (111) sont supérieurs à ceux d'un semi-conducteur formant le puits quantique (110) qui est configuré pour produire l'émission lumineuse du transistor bipolaire.

2. Transistor bipolaire à émission lumineuse (100) selon la revendication 1, dans lequel :
- dans une première partie (112) de la première portion de semi-conducteur (102), les niveaux des bandes d'énergie du semi-conducteur dopé de cette première partie (112) ont des premières valeurs ;
- les niveaux des bandes d'énergie du semi-conducteur dopé de la deuxième portion de semi-conducteur (104) ont des deuxièmes valeurs différentes des premières valeurs ;
- dans une deuxième partie (114) de la première portion de semi-conducteur (102) disposée entre la première partie (112) de la première portion de semi-conducteur (102) et la deuxième portion de semi-conducteur (104), les niveaux des bandes d'énergie du semi-conducteur dopé de cette deuxième partie (114) varient en passant des premières valeurs aux deuxièmes valeurs ;
- le ou les puits quantiques (110) sont disposés dans la deuxième partie (114) de la première portion de semi-conducteur (102).

3. Transistor bipolaire à émission lumineuse (100) selon la revendication 2, comportant en outre une deuxième couche barrière (116) disposée dans la deuxième partie (114) de la première portion de semi-conducteur (102) et telle que le ou les puits quantiques (110) soient disposés entre la deuxième couche barrière (116) et la deuxième portion de semi-conducteur (104).

4. Transistor bipolaire à émission lumineuse (100) selon l'une des revendications précédentes, comportant plusieurs puits quantiques (110) disposés dans la première portion de semi-conducteur (102) et tels que chaque puits quantique (110) soit séparé d'un puits quantique (110) voisin par au moins une couche barrière intermédiaire (113) formée par le semi-conducteur dopé de la première portion de semi-conducteur (102).

5. Transistor bipolaire à émission lumineuse (100) selon l'une des revendications précédentes, dans lequel :
- les première, deuxième et troisième portions de semi-conducteur (102, 104, 106) comportent du GaN, et le ou les puits quantiques (110) comportent de l'InGaN, ou
- les première, deuxième et troisième portions de semi-conducteur (102, 104, 106) comportent du GaAs, et le ou les puits quantiques (110) comportent de l'InGaAs, ou
- les première, deuxième et troisième portions de semi-conducteur (102, 104, 106) comportent de l'InP, et le ou les puits quantiques (110) comportent du GalnP, ou
- les première, deuxième et troisième portions de semi-conducteur (102, 104, 106) comportent de l'AIGaAs, et le ou les puits quantiques (110) comportent de l'InAlGaAs.

6. Transistor bipolaire à émission lumineuse (100) selon l'une des revendications précédentes, dans lequel la composition atomique du semi-conducteur dopé de la première portion de semi-conducteur (102) est différente de celle du semi-conducteur dopé de la deuxième portion et/ou de la troisième portion de semi-conducteur (104, 106).

7. Dispositif émissif lumineux (300) comprenant :
- au moins un transistor bipolaire à émission lumineuse (100) selon l'une des revendications précédentes,
- au moins un circuit de polarisation (304) du ou des transistors bipolaires à émission lumineuse (100), configuré pour polariser le ou les transistors bipolaires à émission lumineuse (100) en émetteur commun.

8. Dispositif (300) selon la revendication 7, comprenant une matrice (302) de transistors bipolaires à émission lumineuse (100) formant un écran.

9. Procédé de réalisation d'un transistor bipolaire à émission lumineuse (100) selon l'une des revendications 1 à 6, dans lequel les première, deuxième et troisième portions de semi-conducteur (102, 104, 106) et le ou les puits quantiques (110) sont réalisés par la mise en œuvre d'étapes d'épitaxie et de dopage.
